# EUROPEAN PATENT APPLICATION

(11) **EP 2 858 114 A1**
(43) Date of publication of application: **08.04.2015**
(21) Application number: 13186889.5
(22) Date of filing: 01.10.2013
(51) Int. Cl.: H01L 29/417, H01L 29/786, H01L 51/05, H01L 51/10, H01L 29/40

(54) **Transistor device and method of manufacturing such a device**

(71) Applicant: Nederlandse Organisatie voor Toegepast -Natuurwetenschappelijk Onderzoek TNO, 2628 VK Delft (NL)
(72) Inventor: Torricelli, Fabrizio, 5612 AZ Eindhoven (NL); Raiteri, Daniele, 5612 AZ Eindhoven (NL)
(74) Representative: Jansen, Cornelis Marinus

(57) **Abstract**

The invention provides a transistor device comprising a semiconductor layer, a primary source electrode, a primary drain electrode and a primary gate electrode, wherein the primary source electrode and the primary drain electrode are in contact with the semiconductor layer, and wherein the primary gate electrode is at a first side of the semiconductor layer having a gate insulating layer in between. The device further comprises auxiliary electrodes separated from the semiconductor layer by an auxiliary insulating layer. The auxiliary electrodes are in relation to the semiconductor layer at a second side opposite the first side. At least one of the one or more auxiliary electrodes at least partially overlaps either one of the primary source or the primary drain electrode for inducing an electrostatic field which extends in the semiconductor layer near the primary source or drain electrode for reducing the contact resistance and/or short channel effects. The invention further provides a method of manufacturing.

## Description

### Field of the Invention

The invention is directed at a transistor device comprising a semiconductor layer, a primary source electrode, a primary drain electrode and a primary gate electrode, wherein the primary source electrode and the primary drain electrode are located in the device such as to be in contact with the semiconductor layer, and wherein the primary gate electrode is located at a first side of the semiconductor layer having a gate insulating layer arranged in between the semiconductor layer and the primary gate electrode. The invention is further directed at a and method of manufacturing a transistor device.

### Background

The transistor is the key active component in practically all modern electronics. Depending on the materials and fabrication process, different transistor structures have been proposed in the past. The first transistor, conceived and patented by J. E. Lilienfeld in 1925, was a field-effect transistor (FET) and it was intended to be a solid-state replacement for the vacuum tube thermionic triode. The first working transistor, the bipolar point-contact transistor, was invented by Bardeen, Brattain, and Shockley in 1947. The first Metal-Oxide-Semiconductor (MOS) transistor actually built was by Kahng and Atalla at Bell Labs in 1960.

More recently, the thin-film technology led to the invention and development of the thin-film transistor (TFT). Although in the past it was mainly used as electronic switch of the pixels in liquid-crystal displays, more recently the TFT have gained an increasing attention for the development of many low-cost large-area, flexible and even disposable applications, like OLED and e-ink displays, large-area sensors, RFIDs, etc. This renewed and broader interest in TFTs is basically due to the discovery and the development of cheap and low-temperature technologies that enable large-area electronics using materials like organic semiconductors and metal-oxide semiconductors.

The basic structure of a thin-film transistor is a sandwich of four layers: a conductor, an insulator, a semiconductor, and another conductor. One metal layer is used to define the control electrode (gate) while the other metal layer define the electrodes through which the transistor current (source S and drain D) is injected and extracted from the active material (i.e. the semiconductor). Thin-film transistor structures are generally categorized in four known types. One can speak of top- or bottom-gate structures according to the mutual position of gate and semiconductor. The top-gate structure has the gate electrode atop the semiconductor layer, while the bottom-gate structure has the gate beneath the semiconductor layer. Another categorization is related to the position of the source and drain. A staggered structure is obtained when the source/drain electrodes are located at the opposite side of the gate electrode with respect to the semiconductor layer. In a planar structure all electrodes are located at the same side of the semiconductor layer.

To achieve the maximum thin-film transistor performance, a challenging subject is to realize efficient carrier injection and extraction at the electrodes. Emerging technologies based for example on amorphous silicon, organic, metal-oxide and low temperature graphene transistors are seriously affected by the problem of obtaining a low enough contact resistant. This is inherently due to the materials and fabrication process: it is very challenging to exactly match the energetic properties of the metal electrodes with the ones of the semiconductor. It is well known that energy level misalignments, local electric dipoles, trap states, and voids give rise to high energy barriers at the metal-semiconductor interfaces; thus leading to high parasitic contact resistances and large and hardly predictable process variations. These problems are limiting the reliability and the maximum achievable complexity of the circuits based on thin-film transistors.

Moreover, the reduction of the contact resistance is essential to exploit the full benefit of down-scaling the transistor channel length in terms of increased current drive, enabling higher switching speed. Contact resistance has also a detrimental effect on the minimum supply voltage needed for digital and analogue circuits, and thus on power consumption.

Finally, it is worth noting that the higher the mobility of the semiconductor material, the more important is to create high-quality contacts due to the large currents achieved by the transistor. One may appreciate that high mobility semiconductors are not useful without efficient contacts (i.e. with low contact resistance, stable, and preferably cheap electrodes).

### Summary of the Invention

It is an object of the present invention to provide a transistor device, in particular a thin-film transistor device, having a low contact resistance between the source and drain electrodes and the semiconductor material. It is a further object to reduce short channel effects in such transistor devices. In particular this is to be achieved without diminishing or jeopardizing proper functioning and influence of the gate electrode.

This is achieved by the present invention in that there is provided a transistor device comprising a semiconductor layer, a primary source electrode, a primary drain electrode and a primary gate electrode, wherein the primary source electrode and the primary drain electrode are located in the device such as to be in contact with the semiconductor layer, and wherein the primary gate electrode is located at a first side of the semiconductor layer having a gate insulating layer arranged in between the semiconductor layer and the primary gate electrode, said device further comprising one or more auxiliary electrodes separated from the semiconductor layer by an auxiliary insulating layer, wherein the auxiliary electrodes and the auxiliary insulating layer are located in relation to the semiconductor layer at a second side opposite the first side, wherein at least one of the one or more auxiliary electrodes is located at the second side such as to at least partially overlap either one of the primary source or the primary drain electrode, such that in use the at least one auxiliary electrode allows for inducing an electrostatic field which extends in the semiconductor layer near said one of the primary source electrode or the primary drain electrodes for reducing the contact resistance thereof.

The invention is a thin-film transistor structure able to dramatically reduce the contact resistance at the source and/or drain electrodes as well as increase the intrinsic gain of a transistor working in accumulation mode. This is achieved by electrostatically coupling the source and drain electrodes with other metal electrodes, i.e. auxiliary electrodes, defined on the opposite side of the gate electrode. These auxiliary electrodes include at least one of an auxiliary source electrode or an auxiliary drain electrode, and preferably both.

The invention is based on the insight that by means of a proper electric potential applied to the at least one auxiliary electrode, it is possible to locally (i.e. close to the at least one auxiliary electrode) modify the electric field and the charge distribution within the semiconductor region, eventually leading to an improvement of the charge injection or extraction from the primary source or drain electrode (whichever is overlapped by the at least one auxiliary electrode). In particular, this mechanism can be harnessed to lower the contact resistance, to reduce (or even cancel) the channel modulation and to increase the intrinsic gain of the transistor, i.e. the transconductance gₘ and the output resistance rₒ.

With reference to the above it is noted that, in addition to the already explained contact resistance, the channel length modulation and the kink effect are other fundamental mechanisms taking place at interface between semiconductor and metal contact. These mechanisms reduce the output resistance and the intrinsic gain of the transistor, especially in short channel devices. This is an important issue since a low intrinsic gain is the main hampering factor in the design of both digital and analog circuits. Indeed a digital gate made with devices characterized by poor intrinsic gain would also achieve small gain, resulting in small noise margin and weak signal regeneration. In the field of analog design, high intrinsic gain is mandatory to be able to exploit all the benefits of feedback configurations. Therefore, the effects achieved by the auxiliary electrodes of the present invention constitutes an important advantage over existing thin film transistor types.

The at least one auxiliary electrode may in a most simple embodiment only comprise a single auxiliary electrode, and in other embodiments comprise two or even more auxiliary electrodes. Each of the auxiliary electrodes at least partially or preferably completely overlaps only one of the primary electrodes. As described, the each of the at least one auxiliary electrode is an electrode that at least partially or preferably completely overlaps either one of the primary source electrode or the primary drain electrode. In other words, the at least one auxiliary electrode may overlap the primary source electrode, or may overlap the primary drain electrode. More preferably, there may be both an auxiliary electrode that overlaps the primary source electrode and an auxiliary electrode that overlaps the primary drain electrode (although they are not overlapped by the same auxiliary electrode).

The auxiliary electrode overlapping a primary source electrode may in some embodiments be termed an auxiliary source electrode, and in other embodiments, where these auxiliary electrodes are located on the top side of the transistor, may be termed a top-source electrode. The auxiliary electrode overlapping a primary drain electrode may in some embodiments be termed an auxiliary drain electrode, and in other embodiments, where these auxiliary electrodes are located on the top side of the transistor, may be termed a top-drain electrode. The auxiliary electrode may also comprise further electrodes, as will be explained later.

In accordance with preferred embodiments, the at least one auxiliary electrode is wider than or extends over the source or drain electrode which is overlapped, such as to at least partially or slightly overlapping the current channel which is in use formed between the source and the drain through control of the gate electrode. Since the auxiliary electrodes behave as virtual ohmic contacts, they give rise to additional contributory currents of charge carriers that effectively reduce the contact resistance. This effect becomes optimal in the present embodiment wherein the current channel between the primary source and drain is slightly overlapped by the auxiliary electrodes that overlap the primary electrodes, where these auxiliary electrodes exceed the outer perimeters of the primary electrodes extending slightly over the channel.

The size of the auxiliary electrodes in relation to the size of the primary electrodes depends on a number of factors. Also the size and overextension of the auxiliary source and auxiliary drain may be different dependent on the situation and design. However, to provide exemplary values that are not to be interpreted as limiting, the sizes may be as follows. For an auxiliary source overlapping with the primary source (i.e. if the source is 5µm the auxiliary source should be 5 µm), an overextension of >50nm is preferred. Larger extensions are also fine and do not compromise the functionality. For an auxiliary drain overlapping with the primary drain electrode, the overextension may preferably be of the order of 1µm depending on the thickness of the auxiliary insulating layer, the gate-drain maximum potential, and on the semiconductor doping.

A preferred embodiment comprises both an auxiliary source electrode and an auxiliary drain electrode. In this embodiment the contact resistance at both primary electrodes is effectively reduced, allowing effective injection, extraction and transportation of charge carriers in the semiconductor layer of the transistor.

In an alternative embodiment, the one or more auxiliary electrodes further comprise an auxiliary gate electrode located in use on the second side such as to overlap the current channel between the primary source and primary drain electrode. In this alternative embodiment, the auxiliary source and drain electrodes effectively lower the contact resistance and the channel modulation, while also improving the intrinsic gain of the transistor, as described above. The auxiliary gain electrode, in addition to the advantages provided by the auxiliary source and drain electrodes, provides a dual-gate transistor configuration which in combination with the other auxiliary electrodes has been found to make the threshold voltage of the transistor tunable.

The teachings of the invention are useful in the field of thin film transistors. Embodiments of the invention include transistor device types such as a planar bottom gate type thin-film transistor or a planar top gate type thin-film transistor. The invention provides thin film transistors with improved intrinsic performance, without requiring the use of different materials or processes (although this is of course not prohibited). In particular, the thin-film transistor architecture effectively lower the contact resistance at the source and drain electrodes, virtually achieving ohmic-like contacts. As a further advantage, the output resistance and the intrinsic gain of the transistor are improved. These achievements are obtained by means of conductive regions overlapped to and wider than the source and drain electrodes of the transistor.

According to a second aspect thereof, there is provided a method of manufacturing a transistor device, comprising the steps of: providing a semiconductor layer, and providing a primary source electrode and a primary drain electrode both at a respective location in the device such as to be in contact with the semiconductor layer; and providing a primary gate electrode and a gate insulating layer such that the primary gate electrode is located at a first side of the semiconductor layer having the gate insulating layer arranged in between the semiconductor layer and the primary gate electrode; wherein the method further comprises the steps of: providing one or more auxiliary electrodes and an auxiliary insulating layer such that the one or more auxiliary electrodes are located separated from the semiconductor layer by the auxiliary insulating layer, and such that the auxiliary electrodes and the auxiliary insulating layer are located in relation to the semiconductor layer at a second side opposite the first side; wherein at least one of the one or more auxiliary electrodes is located such as to at least partially overlap either one of the primary source or the primary drain electrode, such that in use of the transistor device after it is manufactured the at least one auxiliary electrode allows for inducing an electrostatic field which extends in the semiconductor layer near said one of the primary source electrode or the primary drain electrode for reducing the contact resistance thereof.

### Brief description of the drawing

The invention will further be elucidated by description of some specific embodiments thereof, making reference to the attached drawings, wherein:
Figure 1 illustrates a schematic cross section of a thin-film transistor in accordance with an embodiment of the present invention;
Figures 2a-2d are graphs of contact resistance Rₚ=Rₛ + R_{d}, extracted from device simulations, as a function of the auxiliary or top source potential for several gate-source voltages in embodiments of the present invention;
Figures 3a and 3b illustrate simulation results of the two-dimensional distribution in a cross section of an embodiment of the present invention of (a) the charge carrier density and (b) the current density in the semiconductor layer;
Figure 4 is a simulation of the transfer characteristics of a bottom gate bottom contact transistor in an embodiment of the present invention with auxiliary source and drain contacts as compared to a common transistor of similar type without such auxiliary contacts;
Figures 5a and 5b illustrate the Early potential V_{Early} (figure 5a) and the intrinsic gain G (figure 5b) as function of the potential on the auxiliary drain contact extracted from accumulation-mode thin-film transistors with different lengths in accordance with the present invention;
Figures 6a and 6b illustrate the simulated output characteristics of transistors of different channel length, including common type transistors and transistors in accordance with the present invention;
Figures 7a and 7b provide simulated two-dimensional distributions of the hole density (figure 7a) and the current density (figure 7b) in a transistor structure in accordance with an embodiment of the present invention;
Figure 8 illustrates a schematic cross section of a transistor device in accordance with a further embodiment of the present invention;
Figures 9a and 9b illustrate measured transfer characteristics of an organic thin film transistor for several values of the auxiliary gate potential (V_{tg}) in accordance with an embodiment of the invention illustrated in figure 8;
Figure 10 schematically illustrates a method of manufacturing a transistor device in accordance with an embodiment of the present invention.

### Detailed description

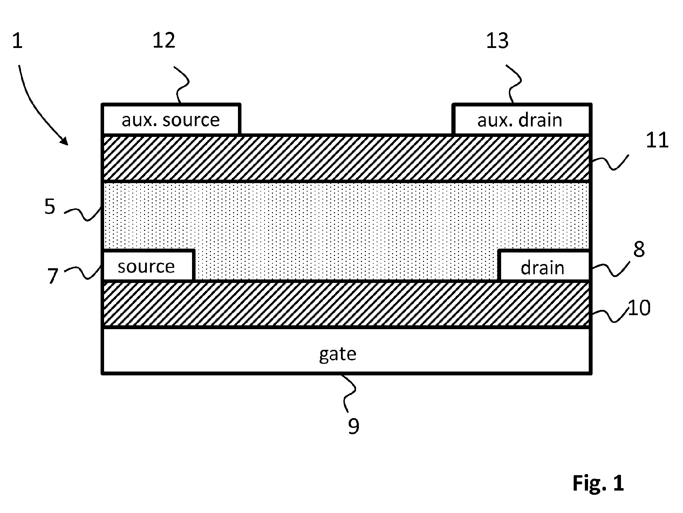

Figure 1 illustrates schematically a cross section of a thin-film transistor device in accordance with an embodiment of the invention, In figure 1, the transistor structure 1 consists of a gate formed by a conductor region 9, and a semiconductor region 5. The gate 9 and the semiconductor layer 5 are separated by an insulator region 10. Within the semiconductor region there are two conductive regions 7 and 8 defined at mutual distance L. Conductor region 7 will form the primary source contact, and conductor region 8 will form the primary drain contact. An insulator region 11 separates the semiconductor region 5 from further conductive regions 12 and 13, which are mutually spatially separated. The further conductor regions 12 and 13 respectively form an auxiliary source electrode 12 and an auxiliary drain electrode 13. Auxiliary source and drain electrodes may alternatively be named control source electrode 12 and control drain electrode 13 respectively. In the embodiment shown, the primary source electrode 7 is overlapped by the auxiliary source electrode 12, and the primary drain electrode 8 is overlapped by the auxiliary drain electrode 13. The auxiliary electrodes 12 and 13 are wider than the associated source 7 and drain 8.

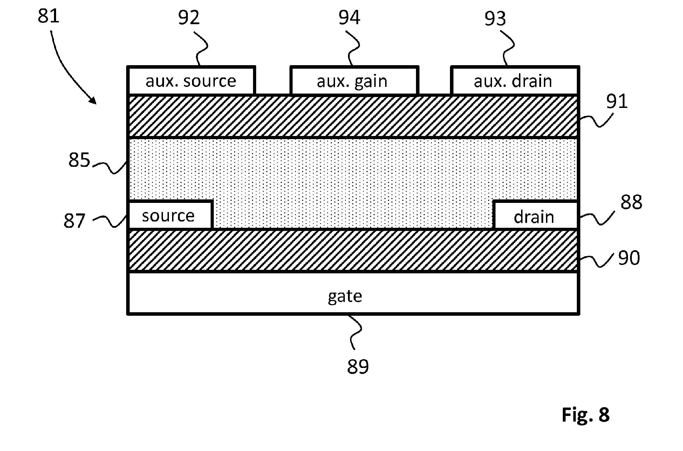

Figure 1 shows an exemplary embodiment of the invention. As may be appreciated, in the embodiment of figure 1 only two auxiliary electrodes 12 and 13 are present. In alternative embodiments of the present invention, any other number of auxiliary electrodes may be present in the device. For example, an embodiment will be illustrated in figure 8 (explained further below) which further comprises an auxiliary gate electrode. Moreover, in the embodiment of figure 1 a single auxiliary source electrode 12 completely overlaps the source 7, while in other embodiments, the auxiliary source electrode may be formed by a plurality of smaller contacts, or an advantageous pattern of contacts. Similarly, also the auxiliary drain electrode may be formed by a multiple different auxiliary drain electrodes or a certain pattern thereof.

Further to the above, in the embodiment of figure 1, the source 7 and drain 8 are embedded in the semiconductor layer. This may not necessarily be the case in all embodiments of the present invention. In alternative embodiments, the source 7 or drain 8 may be present for example in the insulating layer 10 having at least one contact interface with the semiconductor layer 5 alternatively, the source 7 and/or drain 8 may be fully embedded in the semiconductor layer, for example such that the semiconductor layer 5 is completely enclosing the source 7 or drain 8. Moreover, in the embodiment of figure 1 the gate electrode 9 extends over the full width of the device 1, while different configurations of the gate electrode (e.g. smaller gate electrode or multiple gate electrodes) may be present in alternative embodiments of the invention. For example, the gate 9 may only extend partially across the surface of the device, or may be embedded in the insulating layer 10. Moreover, also the auxiliary source electrode 12 and auxiliary drain electrode 13 (or any other configuration of auxiliary contacts) may be fully or partially embedded in the insulating layer 11 (albeit that the insulating layer 11 must separate the auxiliary electrodes 12 and 13 from the semiconductor layer 5).

In the bottom gate planar structure type thin-film transistor of the embodiment of figure 1, since the auxiliary electrodes must be on the opposite side of the semi conductor layer 5 as compared to the gate 9, the auxiliary electrodes 12 and 13 will be on top of the transistor device. In the present embodiment, these auxiliary electrodes may therefore also be referred to as 'top source' 12 and 'top drain' 13. As will be appreciated, the invention may also be applied to a top gate planar structure thin-film transistor, wherein the auxiliary source electrode and auxiliary drain electrode may be at the bottom of the transistor. In the present description, the terms top source and top drain may occasionally be used. These terms will uniformly refer to the auxiliary source electrode and the auxiliary drain electrode of the respective embodiment. In order not to confuse the terminology with the standard terms 'top gate structure' and 'bottom gate structure' for TFT's, an auxiliary gate electrode will not be referred to as top-gate electrode.

In the most basic embodiment of the present invention, the transistor may also include only a single auxiliary electrode, for example an auxiliary source electrode or an auxiliary drain electrode.

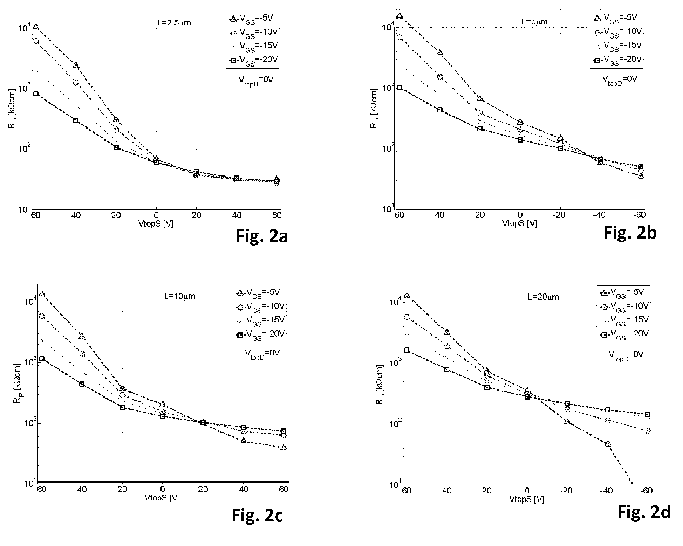

The contact resistance as a function of the top source potential has been calculated from the measured output characteristics. The results obtained for transistors in accordance with the embodiment of figure 1 having several channel lengths (L=2.5µm, L=5µm, L=10µm, L=20µm) are presented in figures 2a, 2b, 2c and 2d respectively. The graphs of figures 2a-2d provide the extracted contact resistance Rₚ=Rₛ+R_{d} as a function of the top source potential at auxiliary source electrode 12 for several gate-source voltages V_{GS} between source 7 and gate 9 and at several channel lengths (figure 2a: L=2.5µm, figure 2b: L=5µm, figure 2c: L=10µm, figure 2d: L=20µm). The top drain potential at auxiliary drain electrode 13 is 0V, to deplete the semiconductor under the top drain and avoid a flow of current in the top channel. The contact resistance Rp is lowered by more than two orders of magnitude (Rₚmax=10MΩcm, Rpmin<100kΩcm)) tuning the top source potential.

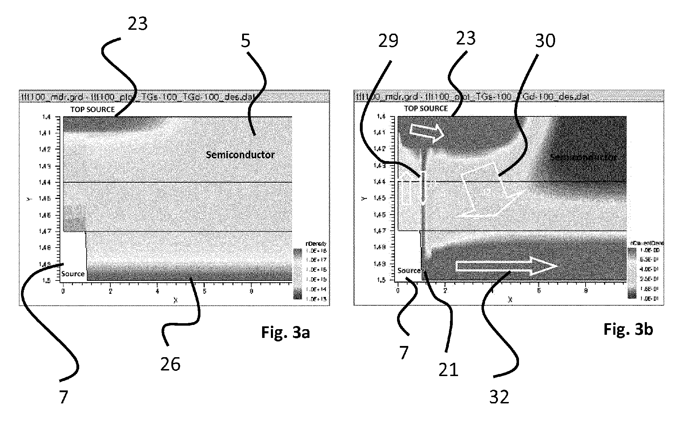

The reduction of the contact resistance eventually leading to better transistor performance has also been studied by means of numerical simulation. In particular, the two-dimensional distribution of the charge carrier concentration and the current density at the source injecting contact 7 in presence of the top source 12 in an embodiment as illustrated in figure 1 are shown in Figs. 3a and 3b, respectively. Figures 3a and 3b illustrate the simulated two-dimensional distribution of the hole density (figure 3a) and the current density (figure 3b) in the semiconductor region 5 close to the source contact 7. The gate 9, insulator layer 10, insulator layer 11 and the top source contact 12 are not shown (although the influence of the top source contact 12 is clearly visible as region 23). The thickness of insulator layer 10 is 350nm, the thickness of insulator 11 is 1.4µm (1400nm). The position of the top source is also indicated by the label "TOP SOURCE" near region 23. The Schottky barrier at the source-semiconductor interface near source 7 is 0.4eV. The semiconductor properties of semiconductor layer 5 are: EV=2.9eV, EC=5.2eV, µ=1cm²/Vs. The scale of the X and Y axes are in micrometers. The applied potentials are: V_{S}=0V, V_{D}=-2V, V_{G}=-10V, V_{TS}=-100V (potential of the auxiliary source electrode 12), V_{TD}=-100V (potential of the auxiliary drain electrode 13). The top source contact 12 overlaps the source 7 completely and extends across the edge of the source 7 over the channel 26 for 1µm.

The charge carriers are extracted from the top surface of the source contact 7 by means of a vertical electric field due to the potential applied to the top source 12. Charge carriers are accumulated at the insulator-to-semiconductor interface region 23 (the top-left dark region of figure 3a (this region is red in colour prints)). In steady-state conditions, the accumulated charges shield the electric field due to the top source potential at auxiliary source contact 12. This high-conductivity region behaves like a virtual ohmic contact for the bottom-gate transistor 1. Two current contributions J1 (reference numeral 29) and J2 (reference numeral 30) are clearly visible in Fig. 3b and they are indicated by the white arrows 29 and 30 pointing toward the bottom channel 26 (arrow indicates 32 is the source drain channel current I_{DS}). In particular, the contribution J1 29 is due to the unshielded electric field of the gate 9. This is because the contact barrier at the source metal-semiconductor interface of source 7 gives rise to a depleted region 21 in the semiconductor layer 5 immediately close to the source contact 7, which is usually responsible of the high contact resistance. It is worth noting that the larger is this depleted region, the higher is the current provided by the top-source virtual contact 12. Hence, the invention is able to cancel "automatically" the contact resistance.

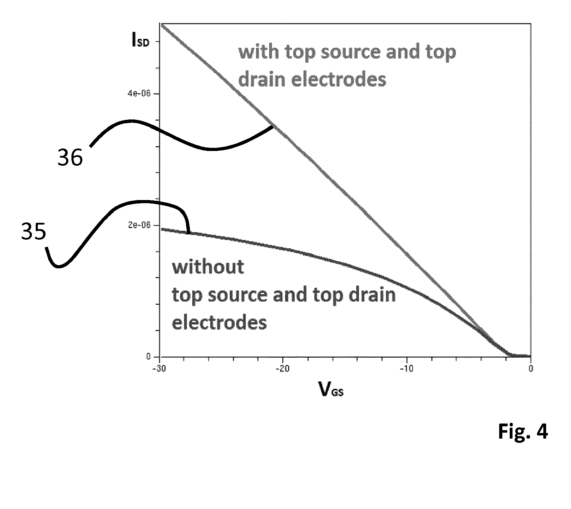

The improvements of the transistor performance are clear from the transfer characteristics reported in Fig. 4. Figure 4 illustrates the transfer characteristics of a bottom gate bottom contact transistor without and with the top source 12 and top drain electrode 13. The transistor W/L = 1000µm/100µm in both cases. The other simulation parameters are identical to the parameters provided in the description of the simulation of figures 3a and 3b above.

The drain current of the common type bottom gate bottom contact transistor of the prior art, without an auxiliary source contact and auxiliary drain contact is severely contact limited, as follows from curve 35. When the top source 12 and top drain electrodes 13 are added, an ohmic like contact is achieved as evident from curve 36.

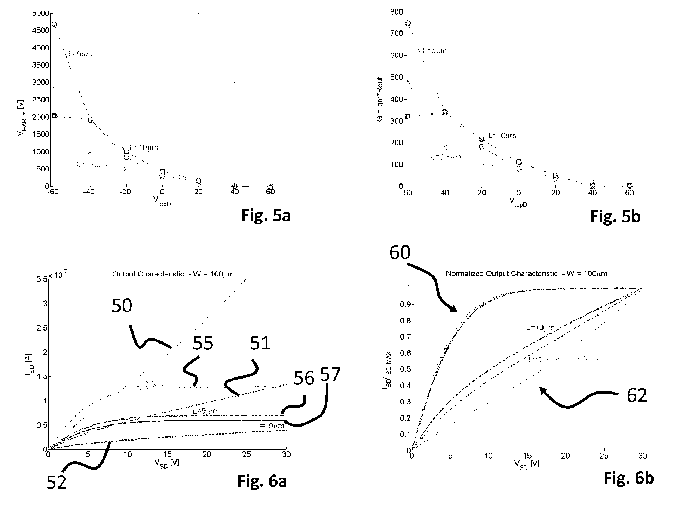

The transistor structure proposed in this invention is also able to greatly reduce the channel length modulation and to increase the intrinsic gain of the transistor by means of the top drain electrode. The channel length modulation is quantified by means of the Early potential V_{EARLY} extracted from the measured output characteristics. The intrinsic gain of the transistor is defined as the product of the transconductance gₘ=dI_{DS}/dV_{GS} and the output resistance rₒ=dV_{DS}/dI_{DS}. According to the embodiment of Fig. 1, thin-film transistors with different channel lengths L have been fabricated, tested and measured. The Early potential and the intrinsic gain as a function of the top drain potential are displayed in Figs. 5a and 5b, respectively. Figure 5a illustrates the Early potential V_{EARLY} and figure 5b the intrinsic gain G as a function of the top drain potential measured from accumulation-mode thin-film transistors with different channel lengths. The Early potential V_{EARLY} and intrinsic gain G significantly increase at large negative potential at the top drain contact 13.

A transistor structure according to the embodiment of Fig. 1 is compared to a "classic" common planar bottom gate transistor without auxiliary electrodes. Figures 6a and 6b illustrate measured output characteristics of transistors with different channel lengths. The bottom gate potential is V_{G}=-5V. Dashed lines 50, 51 and 52, and 62 in figure 6b, are the results for the "classic" planar bottom gate transistor. Full lines 55, 56 and 57, and 60 in figure 6b, are the results for this invention, by adopting a transistor structure according to the embodiment of Fig. 4. The potentials of the top source and top drain are V_{topD}= V_{topS}= -60V. The measured output characteristics of the two transistors are displayed in Fig. 6a (full (55, 56, and 57) and dashed lines (50, 51, and 52)). It is worth noting that the two transistors can be directly compared because they have been fabricated together, with the same process and materials; they are spatially close by and they have the same channel width W and length L. The measurements clearly show that the transistor structure proposed in this invention (curves 55, 56 and 57) drives a larger current with less channel modulation with respect to the planar bottom gate transistor (curves 50, 51 and 52). Furthermore, the short-channel effects are completely suppressed. They are evident in the case of a transistor operating in saturation region with a channel length of L=2.5µm: the drain current of a "classic" planar bottom gate transistor (line 50 in Fig. 6a) non-linearly increases with the drain-source voltage while the drain current of the transistor structure proposed by this invention is completely independent of the VDS potential (line 55 in Fig. 6a).

In Fig. 6b the measured current is normalized with respect its maximum value. The results for the embodiment of the invention is provided by the lines generally indicated by reference numeral 60, while for the common type transistor the results are plotted as lines 62. This plot demonstrates the effectiveness of the proposed invention: the saturation current is independent of the drain voltage as well as of the channel length.

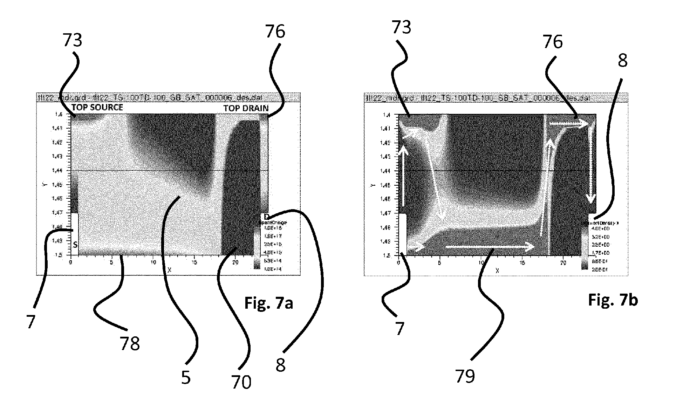

The embodiment drawn in Fig. 1 has been also studied by means of numerical simulations. The two-dimensional distribution of the charge carrier concentration and the current density in an accumulation-mode transistor are displayed in Figs. 7a and 7b, respectively. These figures illustrate the location of the source 7 and drain 8 in the semiconductor layer 5. The gate 9, insulating layers 10 and 11, and the auxiliary source and drain electrodes 12 and 13 are not visible in these figures, however the influence of the auxiliary source and drain electrodes 12 and 13 is visible as regions 73 and 76 in the top-left and top-right corners of the figures. Figures 7a and 7b provide the two-dimensional distribution of the hole density (figure 7a) and the current density (figure 7b) in the transistor structure 1. The thickness of insulator 10 thickness is 350nm, the thickness of insulator 11 is 1400nm (1.4µm). Although the auxiliary source and drain electrodes 12 and 13 are not illustrated in figures 7a and 7b, their positions above the semiconductor layer 5 are generally indicated by the label "TOP SOURCE" and "TOP DRAIN", respectively. The physical parameters of the transistor are the same as reported in relation to figures 3a and 3b. The applied potentials are: V_{S}=0V, V_{D}=-20V, V_{G}=-5V, V_{TS}=-100V, V_{TD}=-100V. The top source electrode geometrically extends for 1µm after the source electrode edge. The top drain electrode 12 geometrically extends for 1µm across the edge of drain electrode 7 over the channel 78.

The transistor is operating in saturation condition (i.e. V_{DS}>V_{GS}-V_{T}). This is confirmed by the Fig. 7a: the charge accumulated in the bottom channel 78 is reducing going from the source 7 to the drain 8. The semiconductor 5 is fully depleted at the bottom drain side 70. It is worth noting that thanks to the potential applied to the top source and drain electrodes 12 and 13, it is possible to form accumulated regions 73 and 76 on the opposite sides of the source and drain electrodes 12 and 13 in the semiconductor layer 5.

The current density in the transistor is given in Fig. 7b and the current flow is indicated by the white arrows, such as arrow 79. The charges are injected by the virtual source contact, i.e. the accumulated region 73 in correspondence of the top source electrode 12. The charge carriers move in the bottom channel 78 (current 79), and then due to the internal electric field the charge carriers flow to the drain virtual contact, i.e. the accumulated region 76 in correspondence of the top drain electrode 13. From the virtual drain contact 76 they are collected through the upper surface area of the drain electrode 8. Since the virtual drain contact 76 is basically not affected by the drain potential of the drain 8, the drain current is independent of the source-drain voltage V_{DS} between source 7 and drain 8. This explains why it is possible to greatly reduce the channel modulation of channel 78 and to increase the intrinsic gain of the transistor 1.

A further possible embodiment of the present invention is illustrated in figure 8 as transistor device 81. A conductive region 94, i.e. an auxiliary gate electrode 94, is present between auxiliary source electrode 92 and auxiliary drain electrode 93 is present. The insulating layers 90 and 91, the semiconductor layer 85 with the primary source electrode 87 and primary drain electrode 88 embedded therein, and the primary gate electrode 89 are similar to the design of the corresponding elements of transistor 1 in figure 1. As explained above, the auxiliary source electrode 92 and auxiliary drain electrode 93 are used to lower the contact resistance, the channel modulation, and to improve the intrinsic gain of the transistor 81. The auxiliary gate electrode 94 provides a secondary gate such as to provide a dual-gate configuration. Hence, this thin-film transistor structure 81 combines the advantages of a dual-gate transistor together with low contact resistances and small channel modulation (i.e. high intrinsic gain).

As may be appreciated, without departing from the teachings of the invention, other configurations of electrodes may be applied in different embodiments of the design of the present invention. For example, the locations of the auxiliary electrodes 92, 93 and 94 may be reversed with gate electrode 89 while at the same time the source 87 and drain 88 may be differently embedded in the semiconductor layer 85 to make sure that the semiconductor layer 85 extends in the area between the auxiliary electrodes 92-94 and the source 87 and drain 88.

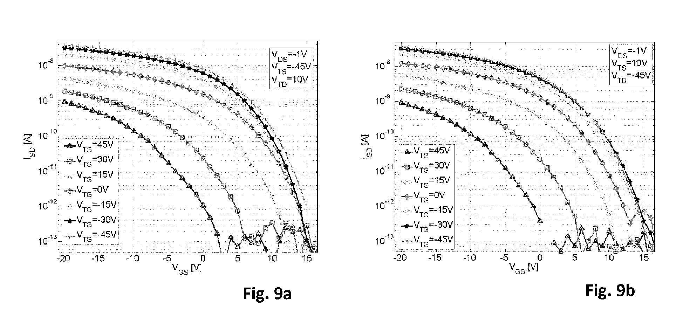

For testing purposes, an organic accumulation-mode thin-film transistor has been fabricated according to the embodiment of figure 8. The measured transfer characteristics as a function of the potential of the auxiliary gate electrode 94 are plotted in figures 9a and 9b. In particular, because of the applied potentials, in figure 9a the virtual ohmic contact is only at the side of source 87; while the auxiliary drain 93 is biased in order to avoid a current flow in a top channel (not shown in figure 8) in the upper region of semiconductor layer 85. In figure 9b the virtual ohmic contact is only at the side of the drain 88, while the auxiliary source electrode 92 is biased in order to avoid a current flow in a top channel (not shown in figure 8) in the upper region of semiconductor layer 85. Figures 9a and 9b are plotted for several values of the auxiliary gate potential V_{TG} of auxiliary gate 94.

The effect of the auxiliary gate 94 on the drain current of the transistor 81 can be readily explained: when the auxiliary gate 94 is positively biased (V_{TG}>0V), no charge is accumulated at the insulator-to-semiconductor interface (i.e. the interface between insulator 91 and semiconductor 85 below the auxiliary gate 94) and the threshold voltage of the transistor 81 can be modulated. In particular, the latter increases for increasing positive auxiliary gate voltages of auxiliary gate 94. On the other hand, when the auxiliary gate is biased with a negative potential (V_{TG}<0), the charge carriers are accumulated at the insulator-to-semiconductor interface (i.e. the interface between insulator 91 and semiconductor 85 below the auxiliary gate 94) and the electric field coming from the auxiliary gate electrode 94 is shielded. In such a condition, the drain current of the transistor 81 remains unchanged. In conclusion, the embodiment of figure 8 allows low contact resistances, small channel modulation, high intrinsic gain, and tunability of the threshold voltage.

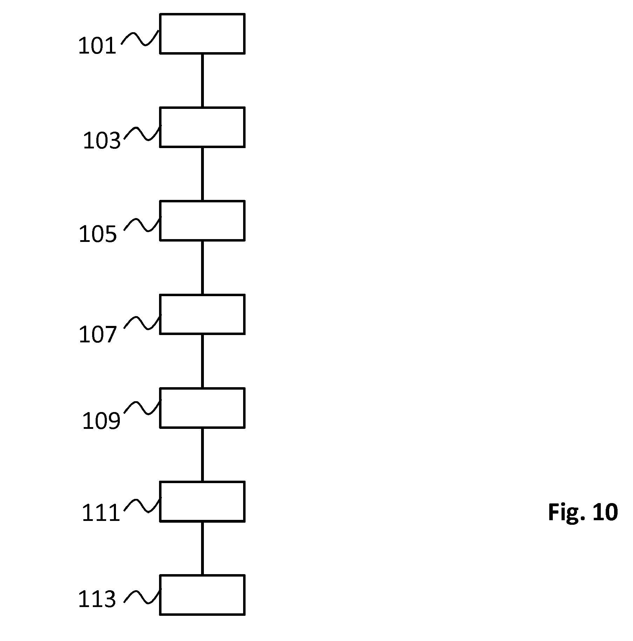

Figure 10 illustrates schematically a method of manufacturing a transistor device in accordance with the present invention. The method illustrated in figure 10 is only one embodiment of the method in accordance with the present invention. In this method, a gate electrode is provided in step 101 upon which an insulator layer is added in step 103. The skilled person will recognize the different techniques and methods that may be applied for achieving these and subsequent steps of the method. On top of the insulating layer, in steps 105, 107 and 109, a semiconductor layer including embedded therein the source and the drain electrode are created. For example, in step 105 a semiconductor layer may be added on top of the insulating layer. The electrodes are created by means of layer deposition and patterning. In step 107, the metal electrodes may be created in the semiconductor layer and in step 109 a further semiconductor layer is added on top of the electrode structure. As will be appreciated, in different configurations of the transistor device, the electrodes may be present in the insulating layer contiguous to the semiconductor layer and a different procedure may be followed. In step 111, a further insulating layer is created on top of the semiconductor layer, and the auxiliary electrodes, such as an auxiliary source and/or an auxiliary drain electrode are created in step 113 such as to provide the electrode configurations of figures 1 and 8 described hereinabove for example.

The effects and advantages of the transistor device and method of the present invention have been explained in detail in this document. In general, it is noted that due to the fact that the auxiliary electrodes, in accordance with the principles of the invention, are located on the other side of the semiconductor layer in comparison to the location of the primary gate electrode, the electrostatic control by the primary gate electrode on the channel is not affected by the present auxiliary electrodes. Moreover, the contact areas for injection and extraction of charge carriers of the primary electrodes into and out of the semiconductor formed by the electrode width, which is of the order of several micrometers (approximately 5-10 µm). In the embodiments of the present invention, the auxiliary drain electrodes provide an additional contact above the drain of the transistor. This additional contact allows the generation of an alternative path to the drain current, thereby remarkably widening the extraction surface of the drain electrode. In fact, with a sufficiently negative bias of the auxiliary drain, a highly conductive region is created in the semiconductor underneath the auxiliary drain. The high conductivity of the new region extends the contact and defines the actual channel length of the transistor. If the enclosure of the primary drain contact is enough, all the area around the metal can be considered as a virtual ohmic contact. The variation of the depleted region, between semiconductor and metal, is smaller due to the higher charge density, and remains seized inside the virtual contact. For this reason, the actual channel length is not modulated and all the short-channel effects are completely cancelled out.

The invention combines the lowering of the contact resistance with the improvement of the output resistance, resulting in a two-side improvement to the intrinsic gain. It makes possible the fabrication of transistors with the minimum channel length available from the technology with the benefit of maximum speed, very high gain, and almost complete suppression of the short-channel effects. The invention therefore provides appealing scenario for the design of both analogue and digital circuits in emerging technologies.

Moreover, the dual-gate architecture proposed in accordance with certain embodiments of this invention (see for example the embodiment of figure 8) combines the advantages of a "classic" dual-gate transistor with the advantages offered by the embodiment of figure 1. For example, in the case of a contact limited transistor, the injection is improved by means of the auxiliary source (as described above) and a virtual ohmic contact is achieved. Furthermore, the output resistance and the intrinsic gain can be increased by means of the auxiliary drain. At the same time, the threshold voltage of the transistor is tuned by means of the auxiliary gate.

These benefits are not achievable using a "classic" dual-gate transistor, i.e. without auxiliary source or drain electrodes, where the local potentials and charge concentrations in the channel and contact regions cannot be independently defined. Indeed, when in a "classic" dual-gate transistor the top channel is accumulated, it is independent of the bottom channel and the overall transistor only shows an increase of its transconductance. Therefore, it is not possible to improve the contact resistance and the output resistance when a "classic" dual-gate transistor is used.

In summary, a new transistor architecture has been conceived. By means of an additional contact (i.e. auxiliary source and/or drain electrode) above the primary contact metal (i.e. source and/or drain), a virtual ohmic contact is realized. The contact resistance is dramatically reduced and all the short-channel effects, that degrade the transistor performance in down-scaled thin-film transistors (TFTs), can be reduced or cancelled. The output resistance is therefore channel-length independent and the transistor can be used always at the minimum limit of the technology. The principle underlying the invention can be broadly applied in the field.

The present invention has been described in terms of some specific embodiments thereof. It will be appreciated that the embodiments shown in the drawings and described here and above are intended for illustrative purposes only, and are not by any manner or means intended to be restrictive on the invention. The context of the invention discussed here is merely restricted by the scope of the appended claims.

## Claims

1. Transistor device comprising a semiconductor layer, a primary source electrode, a primary drain electrode and a primary gate electrode, wherein the primary source electrode and the primary drain electrode are located in the device such as to be in contact with the semiconductor layer, and wherein the primary gate electrode is located at a first side of the semiconductor layer having a gate insulating layer arranged in between the semiconductor layer and the primary gate electrode, said device further comprising one or more auxiliary electrodes separated from the semiconductor layer by an auxiliary insulating layer, wherein the auxiliary electrodes and the auxiliary insulating layer are located in relation to the semiconductor layer at a second side opposite the first side, wherein at least one of the one or more auxiliary electrodes is located at the second side such as to at least partially overlap either one of the primary source or the primary drain electrode, such that in use the at least one auxiliary electrode allows for inducing an electrostatic field which extends in the semiconductor layer near said one of the primary source electrode or the primary drain electrodes for reducing the contact resistance thereof.

2. Transistor device in accordance with claim 1, wherein the one or more auxiliary electrodes comprise an electrode that is located such that it at least partially overlaps the primary source electrode for forming an auxiliary source electrode.

3. Transistor device in accordance with claim 2, wherein the auxiliary source electrode relative to the primary source electrode comprises an extension area which extends in use at least partially over a current channel between the primary source and primary drain electrode.

4. Transistor device in accordance with any of the previous claims, wherein the one or more auxiliary electrodes comprise an electrode that is located such that it at least partially overlaps the primary drain electrode for forming an auxiliary drain electrode.

5. Transistor device in accordance with claim 4, wherein the auxiliary drain electrode relative to the primary drain electrode comprises an extension area which extends in use at least partially over a current channel between the primary source and primary drain electrode.

6. Transistor device in accordance with any of claims 2 or 3, and in accordance with any of claims 4 or 5, comprising both said auxiliary source electrode and said auxiliary drain electrode.

7. Transistor device in accordance with any of the previous claims, wherein the semiconductor layer extends at least partially in between the auxiliary insulating layer and the at least one of the primary source and drain electrodes.

8. Transistor device in accordance with any of the previous claims, wherein the primary source electrode and the primary drain electrode are at least partially or fully embedded in the semiconductor layer.

9. Transistor device in accordance with any of the previous claims, wherein the one or more auxiliary electrodes further comprise an auxiliary gate electrode located in use on the second side such as to overlap the current channel between the primary source and primary drain electrode.

10. Transistor device in accordance with any of the previous claims, wherein said device is a thin-film transistor device.

11. Transistor device in accordance with claim 10, wherein said transistor device is a planar bottom gate type thin-film transistor or a planar top gate type thin-film transistor.

12. Method of manufacturing a transistor device, comprising the steps of:
providing a semiconductor layer, and providing a primary source electrode and a primary drain electrode both at a respective location in the device such as to be in contact with the semiconductor layer; and
providing a primary gate electrode and a gate insulating layer such that the primary gate electrode is located at a first side of the semiconductor layer having the gate insulating layer arranged in between the semiconductor layer and the primary gate electrode;
wherein the method further comprises the steps of:
providing one or more auxiliary electrodes and an auxiliary insulating layer such that the one or more auxiliary electrodes are located separated from the semiconductor layer by the auxiliary insulating layer, and such that the auxiliary electrodes and the auxiliary insulating layer are located in relation to the semiconductor layer at a second side opposite the first side;
wherein at least one of the one or more auxiliary electrodes is located such as to at least partially overlap either one of the primary source or the primary drain electrode, such that in use of the transistor device after it is manufactured the at least one auxiliary electrode allows for inducing an electrostatic field which extends in the semiconductor layer near said one of the primary source electrode or the primary drain electrode for reducing the contact resistance thereof.

13. Method according to claim 12, wherein the one or more auxiliary electrodes being provided include an electrode that is located such that it at least partially overlaps the primary source electrode for forming an auxiliary source electrode, and wherein the one or more auxiliary electrodes being provided further include an electrode that is located such that it at least partially overlaps the primary drain electrode for forming an auxiliary drain electrode.

14. Method according to any of the claims 12 or 13, wherein the one or more auxiliary electrodes is located such as to completely overlap either one of the primary source or the primary drain electrode.

15. Method according to any one or more of the claims 12-14, wherein the one or more auxiliary electrodes is located such as to extend at least partially across the perimeter of said either one of the primary source or the primary drain electrode such as to partially overlap a current channel which, in use of the transistor after it is manufactured, is present between the primary source electrode and the primary drain electrode.
